# EUROPÄISCHE PATENTSCHRIFT

(11) **EP 1 101 232 B1**
(45) Veröffentlichungstag und Bekanntmachung des Hinweises auf die Patenterteilung: **11.09.2002**
(21) Anmeldenummer: 99948694.7
(22) Anmeldetag: 26.07.1999
(51) Int. Cl.: H01H 37/76

(54) **AN KONTAKTFLÄCHEN EINES SCHALTUNGSSUBSTRATS VERLÖTBARES, AUS BLECH GEFORMTES ELEKTRISCHES BAUELEMENT MIT LÖTSTOP**
ELECTRIC COMPONENT FORMED FROM SHEET METAL, PROVIDED WITH A WELDING ABUTMENT AND THAT CAN BE WELDED ON THE CONTACT SURFACES OF A CIRCUIT SUBSTRATE
COMPOSANT ELECTRIQUE FORME A PARTIR D'UNE TOLE ET MUNI D'UNE BUTEE DE SOUDAGE, POUVANT ETRE SOUDE SUR LES SURFACES DE CONTACT D'UN SUBSTRAT DE CIRCUIT

(30) Priorität: 31.07.1998 DE 29813725 U
(43) Veröffentlichungstag der Anmeldung: 23.05.2001
(73) Patentinhaber: TYCO Electronics Logistics AG, 9323 Steinach (CH)
(72) Erfinder: REHNELT, Karl, D-81249 München (DE); TEMPLIN, Frank, D-10367 Berlin (DE)
(74) Vertreter: Hirsch, Peter, Dipl.-Ing.
(86) Internationale Anmeldenummer: DE9902292
(87) Internationale Veröffentlichungsnummer: WO00008665

(56) Entgegenhaltungen:
- EP-A- 0 352 771
- WO-A-93/26028
- US-A- 5 367 124
- PATENT ABSTRACTS OF JAPAN vol. 009, no. 305 (E-363), 3. Dezember 1985 (1985-12-03) & JP 60 143654 A (MATSUSHITA DENKI SANGYO KK), 29. Juli 1985 (1985-07-29)

## Beschreibung

Die Erfindung betrifft ein an Kontaktflächen eines Schaltungssubstrats verlötbares, aus Blech geformtes elektrisches Bauelement entsprechend dem Oberbegriff des Anspruchs 1 (EP-A-0 352 771).

Aus der EP 0 352 771 A2 ist eine Schmelzsicherung mit wenigstens einem unter Vorspannung mit einer Kontaktfläche eines Schaltungssubstrats verlötbaren Federarm bekannt, die durch ein derartiges Blechbauelement gebildet ist. Derartige Schmelzsicherungen werden benötigt, um Schaltungsteile, insbesondere von Schichtschaltungen, wie z.B. Schichtwiderstände, vor thermischer Überlastung zu schützen. Zu diesem Zweck wird die Kontaktfläche des Substrates mit der der Federarm verlötet ist, so angeordnet, daß zwischen dem gegen thermische Überlastung zu sichernden Schaltungsteil der Schichtschaltung und dem zur Verbindung des Federarmes mit der Kontaktfläche verwendeten Lot ein möglichst guter Wärmekontakt vorhanden ist. Bei geeigneter Wahl des Lotes erweicht das Lot, bevor der zu schützende Schaltungsteil durch Überhitzung Schaden nehmen kann. Der vorgespannte Federarm kommt dadurch frei und kann eine elektrische Verbindung zwischen der Kontaktfläche und dem Federarm unterbrechen, indem er den Bereich der Kontaktfläche verläßt.

Beim Auflöten von aus dünnen Blechen geformten Bauelementen, beispielsweise den beschriebenen Schmelzsicherungen, kann der Bereich der Ausbreitung des Lötzinnes nur unzureichend begrenzt werden. Aufgrund von Kapillareffekten ziehen sich die Lötmedien, also das im Lot befindliche Flußmittel und das Lot selbst, auch außerhalb der vorgesehenen Kontaktflächen in den Spalt zwischen Schaltungssubstrat und Blechstreifen und führen so zu einer unbrauchbaren Verbindung. Selbst wenn das Blechbauelement scheinbar plan direkt auf der Substratoberfläche aufliegt, wird es in der Realität immer auf den höchstgelegenen Punkten der Oberfläche gelagert sein, so daß dazwischen möglicherweise mit dem Auge nicht wahrnehmbare Spalten gebildet sind, die von den Lötmedien eingenommen werden können. Vor allem aber bildet die ggf. mit Lot versehene Kontaktfläche selbst einen definierten Auflagepunkt für das Blechbauelement, der natürlich etwas oberhalb des sonstigen Niveaus der Substratoberfläche liegt.

Die auf diese Weise an unerwünschte Stellen unterhalb des Blechbauelements eingedrungenen Lötmedien können dort zu einer Verharzung führen, die insbesondere im Hinblick auf die oben beschriebene Funktion von Schmelzsicherungen die unerwünschte Wirkung eines Festklebens des Federarms haben kann, der somit nicht mehr in der Lage ist, durch Wegschnellen von der Kontaktfläche die Sicherung funktionsgemäß auszulösen. Dieses Problem erforderte bisher eine aufwendige Nachbearbeitung (Waschen) der kompletten Baugruppe.

Aufgabe vorliegender Erfindung ist es, ein Blechbauelement der eingangs genannten Art so auszubilden, daß sich eine Begrenzung der Lötmedien auf vorherbestimmte Bereiche auf einfache Weise ergibt.

Erfindungsgemäß ergibt sich die Lösung dieser Aufgabe bei einem Blechbauelement der eingangs genannten Art dadurch, daß der an die jeweilige Kontaktfläche angrenzende Abschnitt unmittelbar zur Kontaktfläche hin mit einer bis zur Unterkante des dünnen Abschnitts reichenden und damit zur Substratoberfläche hin offenen Ausnehmung ausgebildet ist, durch die der Fluß der Lötmedien unterbrechbar ist.

Die Erfindung ist besonders vorteilhaft bei einem als Schmelzsicherung mit wenigstens einem unter Vorspannung mit einer Kontaktfläche des Schaltungssubstrats verlötbaren Federarm ausgebildeten Blechbauelement einsetzbar. Erfindungsgemäß ist dann die Verbindung zwischen Federarm und Schaltungssubstrat auf die Lötstelle begrenzt, so daß bei einem Erweichen des Lotes aufgrund von Überhitzung der Federarm und damit die Schmelzsicherung ordnungsgemäß auslösen können.

Ausführungsbeispiele der Erfindung werden nachstehend anhand von vier Figuren noch näher erläutert. Dabei zeigen,
- Figur 1 bis 3: in einer Seitenansicht drei Ausführungsbeispiele eines erfindungsgemäßen Blechbauteils, das auf einem Substrat angeordnet ist,
- Figur 4: in Draufsicht von oben eine Schmelzsicherung, die als bügelförmiges Blechbauteil ausgebildet ist.

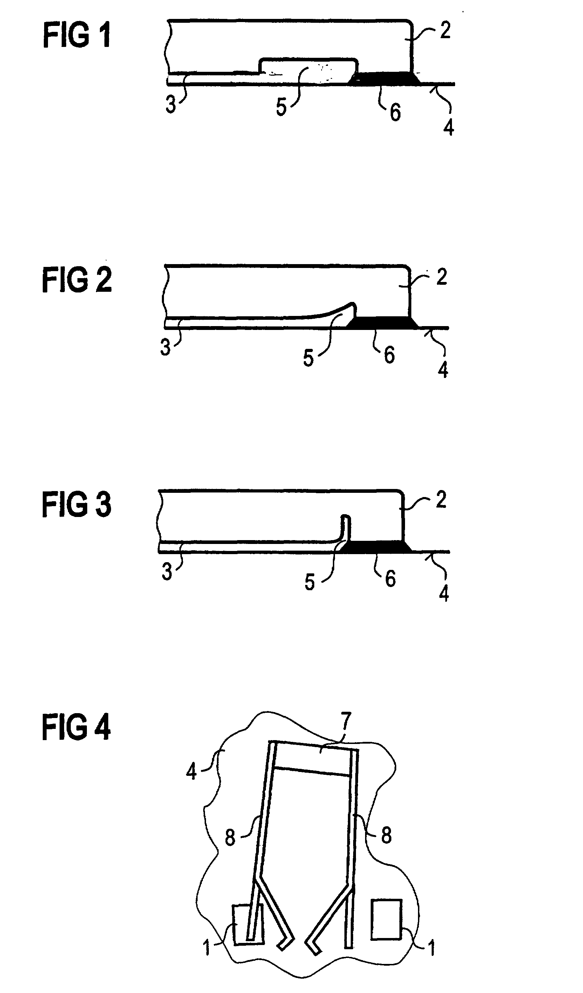

In Figur 1 bis 3 ist jeweils das Ende eines Federarms mit dem Abschnitt 2 dargestellt, wobei die gesamte Anordnung besser in Figur 4 zu erkennen ist, in der eine U-förmige Bügelsicherung 7 mit zwei Federarmen 8 zu erkennen ist, wobei die Enden der Federarme 8 jeweils auf einer Kontaktfläche 1 des Schaltungssubstrats verlötet waren. In Figur 4 ist der rechte Federarm 8 in einer Stellung dargestellt, nachdem er sich von seiner Kontaktfläche 1 gelöst hat.

In den Figuren 1 bis 3 ist jeweils außerdem die Substratoberfläche 4 dargestellt, wobei die mit den Lötmedien6 bedeckte Kontaktfläche einen definierten, erhöhten Auflagepunkt für das Ende des Federarms bilden. Erfindungsgemäß wird in den dünnen Abschnitt 2 (Höhe ca. 1 mm, Breite < 0,1 mm) beispielsweise eine längliche, horizontale Aussparung 5 (Figur 1), eine buckelartige Ausnehmung 5 (Figur 2) oder eine nut- bzw. spaltartige Ausnehmung 5 (Figur 3) eingebracht.

Überraschenderweise kann durch diese einfache Maßnahme eine Abgrenzung des gewünschten Lötbereiches erfolgen, da der Fluß der Lötmedien zu den von der Kontaktfläche 1 weiter entfernten Bereichen des Abschnitts 2 durch die zur Substratoberfläche 4 hin offenen Ausnehmungen 5 unterbrochen wird und somit eine saubere Lötung auf einem begrenzten Raum gewährleistet ist. Selbstverständlich können auch von verschieden Seiten an eine Lötstelle angrenzende Abschnitte 2 jeweils mit einer erfindungsgemäßen Ausnehmung 5 versehen werden.

## Patentansprüche

1. Elektrisches Bauelement, das aus Blech geformt und an Kontaktflächen (1) eines Schaltungssubstrats (4) verlötbar, ist, das in mindestens einem an die jeweilige Kontaktfläche (1) angrenzenden Abschnitt (2) so dünn ist und mit derart geringem Abstand zur Substratoberfläche anzuordnen ist, daß der Bereich der Ausbreitung der Lötmedien aufgrund von Kapillareffekten nicht auf die Kontaktfläche begrenzbar ist, und wobei die Unterkante (3) des dünnen Abschnitts (2) über der jeweiligen Kontaktfläche (1) einerseits und in seitlichen Abstand von der Kontaktfläche (1) andererseits auf einer Linie liegt, **dadurch gekennzeichnet, daß** der an die jeweilige Kontaktfläche (1) angrenzende Abschnitt (2) unmittelbar zur Kontaktfläche (1) hin mit einer bis zur Unterkante (3) des dünnen Abschnitts (2) reichenden und damit zur Substratoberfläche (4) hin offenen Ausnehmung (5) ausgebildet ist, durch die der Fluß der Lötmedien (6) unterbrechbar ist.

2. Elektrisches Bauelement nach Anspruch 1,
**dadurch gekennzeichnet,**
**daß** das Bauelement als Schmelzsicherung (7) mit wenigstens einem unter Vorspannung mit einer Kontaktfläche (1) des Schaltungssubstrats verlötbaren Federarm (8) ausgebildet ist.

## Claims

1. An electrical structural element which is made from sheet metal and is solderable to contact faces (1) of a circuit substrate (4), which is in at least one section (2) adjoining the respective contact face (1) so thin and is to be arranged with respect to the substrate surface with such a small spacing that the region in which the soldering media spread out cannot be limited to the contact face because of capillary effects, and in which the lower edge (3) of the thin section (2) lies on a line at one end above the respective contact face (1) and at the other end at a lateral spacing from the contact face (1), **characterised in that** the section (2) adjacent to the respective contact face (1) is constructed, directly towards the contact face (1), with a recess (5) which extends as far as the lower edge (3) of the thin section (2) and is thus open towards the substrate surface (4), and which allows the flow of soldering media (6) to be interrupted.

2. An electrical structural element according to Claim 1, **characterised in that** the structural element is constructed as a melt fuse (7) having at least one spring arm (8) which is solderable with pre-tension to a contact face (1) of the circuit substrate.

## Revendications

1. Composant électrique, fabriqué à partir de tôle et pouvant être soudé sur des surfaces de contact (1) d'un substrat de circuit (4), comportant au moins une section (2) adjacente à la surface de contact respective (1), tellement fine et agencée à une distance tellement réduite de la surface du substrat que la zone de la propagation des agents à souder par suite d'effets capillaires ne peut pas être limitée à la surface de contact, le bord inférieur (3) de la section fine (2) étant située sur une ligne au-dessus de la surface de contact (1) respective d'une part et à une distance latérale de la surface de contact (1) d'autre part, **caractérisé en ce que** la section (2) adjacente à la surface de contact respective (1), immédiatement en direction de la surface de contact (1), comporte un évidement (5) atteignant le bord inférieur (3) de la section fine (2) et donc ouvert vers la surface du substrat (4), permettant d'interrompre l'écoulement des agents à souder (6).

2. Composant électrique selon la revendication 1, **caractérisé en ce que** le composant a la forme d'un coupe-circuit à fusible (7) comportant au moins un bras élastique (8) pouvant être soudé en présence d'une précontrainte à une surface de contact (1) du substrat du circuit.
